# EUROPÄISCHE PATENTANMELDUNG

(11) **EP 1 292 006 A2**
(43) Veröffentlichungstag der Anmeldung: **12.03.2003**
(21) Anmeldenummer: 02020186.9
(22) Anmeldetag: 09.09.2002
(51) Int. Cl.: H02M 7/00

(54) **Halbbrücke**

(30) Priorität: 11.09.2001 DE 10144671
(71) Anmelder: SIEMENS AKTIENGESELLSCHAFT, 80333 München (DE)
(72) Erfinder: Karrer, Volker, 93055 Regensburg (DE)

(57) **Zusammenfassung**

Halbbrückenschaltung, insbesondere zum Schalten eines Elektromotors in einem Kraftfahrzeug, mit einem masseseitigen Schaltelement (1) mit einem Steuereingang (3, G1), einem spannungsseitigen Schaltelement (2) mit einem Steuereingang (6, G2), wobei das masseseitige Schaltelement (1) und das spannungsseitige Schaltelement (2) zwischen einem Spannungsanschluss und einem Masseanschluss in Reihe geschaltet sind und zwischen dem spannungsseitigen Schaltelement und dem masseseitigen Schaltelement ein Ausgang (OUT) zur Ansteuerung eines elektrischen Verbrauchers angeordnet ist, erfindungsgemäß realisiert durch die Integration in einer integrierten Schaltung.

## Beschreibung

Die Erfindung betrifft eine Halbbrücke mit einem masseseitigen (low-side) Schaltelement und einem spannungsseitigen (high-side) Schaltelement gemäß dem Oberbegriff des Anspruchs 1.

Es ist bekannt, einen Gleichstrommotor mit einer sog. Brückenschaltung zu steuern, die einen Betrieb des Gleichstrommotors in beiden Drehrichtungen ermöglicht. Hierzu weist die bekannte Brückenschaltung vier Schaltelemente beispielsweise in Form von Leistungstransistoren auf, wobei jeweils zwei Schaltelemente zwischen Masse und Versorgungsspannung in Reihe geschaltet sind und eine sog. Halbbrücke bilden. Der Gleichstrommotor ist mit seinen beiden Anschlüssen jeweils mit den Verbindungspunkten der beiden in Reihe geschalteten Schaltelemente der beiden Halbbrücken verbunden. Auf diese Weise kann der Gleichstrommotor durch eine geeignete Ansteuerung der vier Schaltelemente mit einer Spannung der gewünschten Polarität beaufschlagt werden, so dass ein Betrieb des Gleichstrommotors in beiden Drehrichtungen möglich ist. Hierzu wird beispielsweise in der einen Halbbrücke nur das spannungsseitige Schaltelement durchgeschaltet, während in der anderen Halbbrücke nur das masseseitige Schaltelement durchschaltet. Zur Umpolung wird dann in beiden Halbbrücken das jeweils andere Schaltelement durchgeschaltet. Wichtig ist hierbei, das in jeder Halbbrücke nur jeweils eines der beiden Schaltelemente durchschaltet, während das andere Schaltelement sperrt, um einen Kurzschluss entlang der Halbbrücke zu verhindern.

Problematisch hierbei ist die aufbaubedingte parasitäre Induktivität zwischen der Pufferkapazität und dem spannungsseitigen bzw. masseseitigen Schaltelement.

Nachteilig bei einem Aufbau einer derartigen Brückenschaltung mit diskreten Bauelementen ist weiterhin der relativ große Platzbedarf aufgrund der notwendigen Biegegeometrien und Leitungszüge, so dass der Abstand zwischen dem masseseitigen Schaltelement und dem spannungsseitigen Schaltelement relativ groß ist, was zu einer relativ hochinduktiven Anbindung an den Zwischenkreis führt.

Der Erfindung liegt deshalb die Aufgabe zugrunde, die Möglichkeit für eine ohmsch-induktiv optimale, serientaugliche und kostengünstig herstellbare Brückenschaltung zu schaffen.

Die Aufgabe wird, ausgehend von einer diskret aufgebauten bekannten Halbbrückenschaltung gemäß dem Oberbegriff des Anspruchs 1, durch die kennzeichnenden Merkmale des Anspruchs 1 gelöst.

Die Erfindung umfasst die allgemeine technische Lehre, eine Halbbrückenschaltung als integrierte Schaltung auszuführen, wobei das spannungsseitige Schaltelement und das masseseitige Schaltelement gemeinsam auf einem Halbleitersubstrat angeordnet sind. Die Schaltelemente können beispielsweise durch Kleben oder Löten befestigt sein. Vorzugsweise sind auch weitere Bauelemente, wie beispielsweise Pufferkapazitäten und Induktivitäten gemeinsam mit dem masseseitigen bzw. spannungsseitigen Schaltelement auf dem Halbleitersubstrat angeordnet.

Der Begriff der integrierten Schaltung ist hierbei allgemein zu verstehen und umfasst beispielsweise das herkömmliche Begriffsverständnis, wonach zahlreiche elektronische Bauelemente wie Transistoren, Dioden, Kondensatoren und Widerstände gemeinsam auf einem Chip angeordnet sind. Darüber hinaus umfasst der Begriff der integrierten Schaltung im Rahmen der Erfindung auch Schaltungsanordnungen, die lediglich in einem gemeinsamen Gehäuse angeordnet oder umspritzt bzw. eingegossen sind.

Die erfindungsgemäße Halbbrückenschaltung kann beispielsweise auf einem keramischen Substrat oder einer Leiterplatte realisiert werden. Ferner kann die erfindungsgemäße Halbbrückenschaltung umspritzt oder nur als IC montiert sein.

Vorzugsweise handelt es sich bei den Schaltelementen um Leistungstransistoren, wie beispielsweise MOSFETs, die wahlweise an N-MOSFETs oder als P-MOSFETs ausgeführt sein können. Die Erfindung ist jedoch nicht auf diese Typen von Schaltelementen beschränkt. So können beispielsweise auch bipolare Transistoren, Thyristoren oder IGBTs als Schaltelemente verwendet werden.

Unabhängig vom Typ des verwendeten Schaltelementes lassen sich wahlweise Schaltelemente mit einer positiven oder einer negativen Steuerlogik einsetzen, was allgemein bekannt ist. Darüber hinaus können für die beiden Halbbrücken einer Brückenschaltung Schaltelemente mit unterschiedlicher Logiksteuerung verwendet werden. So können die Schaltelemente der einen Halbbrücke beispielsweise eine negative Logikansteuerung aufweisen, während die Schaltelemente der anderen Halbbrücke eine positive Logikansteuerung aufweisen.

Ferner können in Abhängigkeit von der jeweiligen Steuerschaltung wahlweise selbstleitende oder selbstsperrende Schaltelemente eingesetzt werden, was nicht weiter ausgeführt werden muss.

In einer vorteilhaften Variante der Erfindung weist die integrierte Halbbrückenschaltung von den beiden Schaltelementen getrennte elektrisch leitfähige Trägerstreifen auf, die Anschlusskontakte für die beiden Steuereingänge der Schaltelemente, den Masseanschluss, den Spannungsanschluss und/oder den Ausgang bilden, wobei die Trägerstreifen durch elektrische Verbindungsleitungen mit den Schaltelementen der Halbbrückenschaltung verbunden sind. Derartige Trägerstreifen sind auch als Leadframes bekannt und ermöglichen eine einfache Kontaktierung der Halbbrückenschaltung.

In einer anderen Variante der erfindungsgemäßen Halbbrückenschaltung weisen die beiden Schaltelemente dagegen überstehende Leiterbahnen auf, die vorzugsweise aus Kupfer bestehen und eine einfache Kontaktierung ermöglichen, so dass auf separate Trägerstreifen (englisch: leadframes) verzichtet werden kann.

Die Anschlusskontakte der erfindungsgemäßen Halbbrückenschaltung werden also in den beiden vorstehend beschriebenen Varianten entweder durch überstehende Leiterbahnen der Schaltelemente oder durch separate Trägerstreifen gebildet. Vorzugsweise sind die Anschlusskontakte hierbei nebeneinander zu einer Seitenkante der integrierten Schaltung hin angeordnet. Die Anschlusskontakte sind also vorzugsweise länglich und verlaufen im wesentlichen rechtwinklig zu einer Seitenkante der integrierten Schaltung.

In der bevorzugten Ausführungsform der erfindungsgemäßen Halbbrückenschaltung sind die beiden Anschlusskontakte für die Steuereingänge der beiden Schaltelemente jeweils außen angeordnet und bilden vorzugsweise Seitenkanten der integrierten Schaltung. Die anderen Anschlusskontakte der integrierten Schaltung sind vorzugsweise zwischen den beiden Anschlusskontakten für die Steuereingänge der beiden Schaltelemente angeordnet.

In einer Variante der Erfindung ist der Anschlusskontakt für den Ausgang der Halbbrückenschaltung zwischen den beiden Anschlusskontakten für die beiden Steuereingänge der beiden Schaltelemente der Halbbrückenschaltung angeordnet.

In einer anderen Variante der Erfindung ist der Anschlusskontakt für den Ausgang der Halbbrückenschaltung neben den beiden Anschlusskontakten für Masse- und Spannungsanschluss der beiden Schaltelemente angeordnet, was ein Zweilagendesign erleichtert, wobei das Substrat bzw. die Halbbrückenschaltung vorzugsweise einlagig ist, während die Leiterplatte vorzugsweise zweilagig ist. Hierbei sind die beiden Anschlusskontakte für den Spannungsanschluss und den Masseanschluss vorzugsweise unmittelbar nebeneinander angeordnet.

In einer weiterbildenden Variante der Erfindung sind die Trägerstreifen und/oder zusätzliche elektrische Kontaktelemente aufgenietet, aufgelötet oder aufgeschweißt. Die zusätzlichen Kontaktelemente können hierbei eine Bohrung für eine Schraubverbindung oder Zinken für eine Press- oder Lötverbindung aufweisen. Die Zinken eines derartig geformten Kontaktelementes können abwechselnd in zwei zueinander beabstandete parallele Ebenen gebogen sein, um eine hohe Stromtragfähigkeit zu erreichen.

Die Dicke der Trägerstreifen, der überstehenden Leiterbahnen und/oder der zusätzlichen Kontaktelemente liegt vorzugsweise im Bereich von 200 µm bis 400 µm, wobei sich eine Dicke von 300 um als besonders vorteilhaft erwiesen hat.

Andere vorteilhafte Weiterbildungen sind in den Unteransprüchen gekennzeichnet bzw. werden nachstehend zusammen mit der Beschreibung der bevorzugten Ausführungsbeispiele anhand der Figuren näher erläutert. Es zeigen:
- Fig. 1a, 1b: eine erfindungsgemäße integrierte Halbbrückenschaltung mit separaten Trägerstreifen (leadframes) zur Kontaktierung,
- Fig. 2a, 2b: eine alternative Ausführungsform einer erfindungsgemäßen Halbbrückenschaltung mit überstehenden Leiterbahnen der beiden Schaltelemente, die Anschlusskontakte bilden sowie
- Fig. 3a, 3b: Ausführungsbeispiele von zusätzlichen Kontaktelementen.

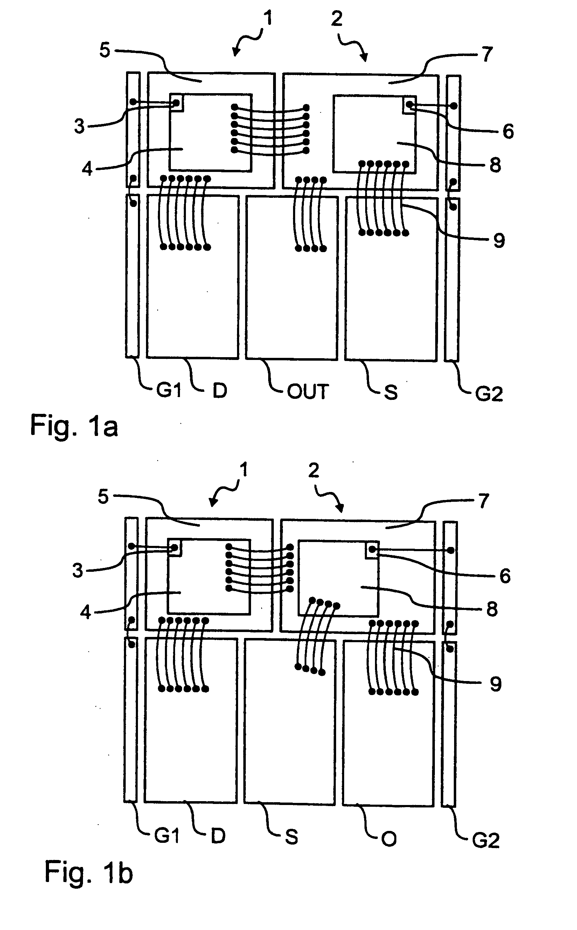

Die in Figur 1a dargestellte integrierte Halbbrückenschaltung dient in Kombination mit einer weiteren Halbbrückenschaltung zur Bildung einer Brückenschaltung für die Ansteuerung eines Elektromotors.

Hierzu weist die Halbbrückenschaltung zwei P-Kanal-MOSFET-Transistoren 1, 2 auf, die zwischen Versorgungsspannung und Masse in Reihe geschaltet sind, wobei der masseseitige (low-side) Transistor 1 einen Gate-Anschluss 3, einen Source-Anschluss 4 und einen Drain-Anschluss 5 aufweist.

Anstelle von zwei P-Kanal-Transistoren können jedoch auch zwei N-Kanal-Transistoren oder ein P-Kanal-Transistor und ein N-Kanal-Transistor verwendet werden.

In gleicher Weise verfügt der spannungsseitige Transistor 2 über einen Gate-Anschluss 6, einen Drain-Anschluss 7 und einen Source-Anschluss 8.

Der Source-Anschluss 8 des spannungsseitigen Transistors 2 ist durch Bonding-Leitungen 9 mit einem separaten und ansonsten elektrisch von dem Transistor 2 isolierten Trägerstreifen S (engl. leadframe) verbunden, der einen Anschlusskontakt zur Verbindung mit der Versorgungsspannung bildet.

Der Drain-Anschluss 7 des spannungsseitigen Transistors 2 ist über Bonding-Leitungen ähnlich den Bonding-Leitungen 9 mit dem Source-Anschluss 4 des masseseitigen Transistors 1 verbunden.

Der Drain-Anschluss 5 des masseseitigen Transistors 1 ist schließlich über Bonding-Leitungen ähnlich den Bonding-Leitungen 9 mit einem separaten und von dem Transistor 1 ansonsten elektrisch isolierten Trägerstreifen D verbunden, der einen Anschlusskontakt zur Verbindung mit Masse bildet.

Die beiden Transistoren 1, 2 sind also zwischen der Versorgungsspannung und Masse in Reihe geschaltet.

Der Gate-Anschluss 3 des masseseitigen Transistors 1 ist über eine Bonding-Leitung mit einem separaten und von dem Transistor 1 ansonsten elektrisch isolierten Trägerstreifen G1 verbunden, der einen Anschlusskontakt zur Ansteuerung des Transistors 1 bildet.
In gleicher Weise ist der Gate-Anschluss 6 des spannungsseitigen Transistors 2.über eine Bonding-Leitung mit einem separaten und von dem Transistor 2 ansonsten elektrisch isolierten Trägerstreifen G2 verbunden, der einen Anschlusskontakt zur Ansteuerung des spannungsseitigen Transistors 2 bildet.

Schließlich ist der Drain-Anschluss 7 des spannungsseitigen Transistors 2 und damit auch der Source-Anschluss 4 des masseseitigen Transistors 1 über Bonding-Leitungen ähnlich den Bonding-Leitungen 9 mit einem separaten und gegenüber den beiden Transistoren 1, 2 ansonsten elektrisch isolierten Trägerstreifen OUT verbunden, der einen Spannungsabgriff für den zu steuernden Gleichstrommotor bildet.

Die vorstehend beschriebene erfindungsgemäße integrierte Halbbrückenschaltung bietet den Vorteil, dass aufgrund des geringen Abstandes zwischen den beiden Schaltelementen der Halbbrücke eine niedrig-induktive Anbindung an den Zwischenkreis möglich ist.

Die Trägerstreifen G1, G2, D, OUT verlaufen hierbei jeweils streifenförmig parallel zueinander und sind selbstverständlich elektrisch gegeneinander isoliert. In dieser Ausführungsform sind die Trägerstreifen G1 und G2 wesentlich schmaler als die restlichen Trägerstreifen und bilden die Seitenkanten der integrierten Schaltung. In der Mitte ist der Trägerstreifen OUT zur Ansteuerung des Gleichstrommotors angeordnet, der seitlich von den beiden Trägerstreifen D, S zur Verbindung mit dem Spannungs- bzw. Masseanschluss umgeben ist.

Figur 1b zeigt ein alternatives Ausführungsbeispiel, das weitgehend mit dem vorstehend beschriebenen und in Figur 1a dargestellten Ausführungsbeispiel übereinstimmt, so dass im folgenden dieselben Bezugszeichen verwendet werden und zur Vermeidung von Wiederholungen weitgehend auf die vorstehende Beschreibung verwiesen wird.

Der Unterschied des in Figur 1b dargestellten Ausführungsbeispiels gegenüber dem in Figur 1a dargestellten Ausführungsbeispiels besteht darin, dass die beiden Trägerstreifen D, S für die Verbindung mit der Versorgungsspannung bzw. mit Masse unmittelbar nebeneinander angeordnet sind, während der Trägerstreifen OUT zur Ansteuerung des Gleichstrommotors außen angeordnet ist. Dies bietet den Vorteil, dass ein Zweilagendesign der integrierten Halbbrückenschaltung leichter realisierbar ist.

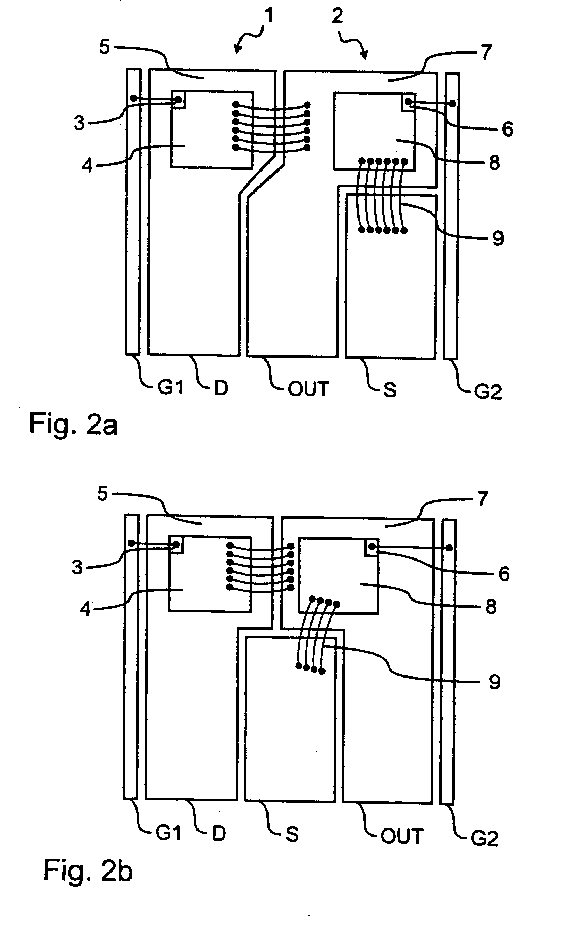

Das in Figur 2a dargestellte alternative Ausführungsbeispiel stimmt ebenfalls weitgehend mit dem in Figur 1a dargestellten Ausführungsbeispiel überein, so dass auch diesbezüglich im folgenden dieselben Bezugszeichen verwendet werden und zur Vermeidung von Wiederholungen auf die Beschreibung zu Figur 1a verwiesen wird.

Die Besonderheit des in Figur 2a dargestellten Ausführungsbeispiels besteht im wesentlichen darin, dass zur Bildung der Anschlusskontakte D, OUT und S keine separaten Trägerstreifen verwendet werden. Vielmehr weisen die beiden Transistoren 1, 2 überstehende Leiterbahnen aus Kupfer aus, welche die Anschlusskontakte für den Masseanschluss, die Versorgungsspannung und den Spannungsabgriff OUT für den Gleichstrommotor bilden.

Der Anschlusskontakt OUT für den anzusteuernden Gleichstrommotor ist hierbei wie in Figur 1a ebenfalls mittig zwischen den beiden Anschlusskontakten D bzw. S für die Versorgungsspannung bzw. Masse angeordnet.

Schließlich stimmt auch das in Figur 2b dargestellte Ausführungsbeispiel weitgehend mit dem in Figur 1a dargestellten Ausführungsbeispiel überein, so dass auch diesbezüglich im folgenden dieselben Bezugszeichen verwendet werden und weitgehend auf die vorstehende Beschreibung zu Figur 1a verwiesen wird.

Die Besonderheit dieses Ausführungsbeispiels besteht zum einen darin, dass keine separaten Trägerstreifen als Anschlusskontakte vorhanden sind. Vielmehr weisen die beiden Transistoren 1, 2 - wie in Figur 2a - überstehende Leiterbahnen auf, welche die Anschlusskontakte zur Verbindung mit der Versorgungsspannung, Masse und dem anzusteuernden Gleichstrommotor bilden.

Zum anderen besteht die Besonderheit des Figur 2b dargestellten Ausführungsbeispiels darin, dass der Anschlusskontakt OUT für den Gleichstrommotor außen neben den beiden zueinander unmittelbar benachbart angeordneten Anschlusskontakten D, S für die Versorgungsspannung bzw. Masse angeordnet ist, was ein Zweilagendesign erleichtert.

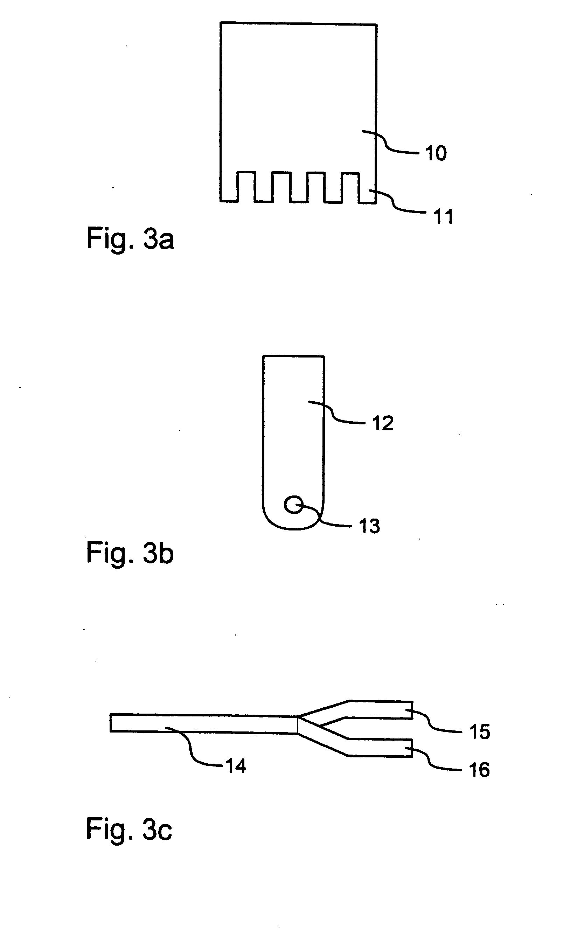

Die Figuren 3a bis 3c zeigen schließlich mögliche Ausführungsformen von zusätzlichen Kontaktelementen, die auf die Trägerstreifen G1, D, OUT, S oder G2 oder die überstehenden Leiterbahnen der Transistoren 1 und 2 aufgepresst, aufgenietet, aufgelötet oder aufgeschweißt werden können, wodurch die Stromtragfähigkeit vorteilhaft erhöht wird.

Hierbei ist zu bemerken, dass auch die Trägerstreifen G1, D, OUT, S und/oder G2 dieselbe Form wie die zusätzlichen Kontaktelemente aufweisen können.

Das in Figur 3a dargestellte Kontaktelement 10 dient zur Herstellung einer Löt- oder Pressverbindung und weist hierzu mehrere Zinken 11 auf, die äquidistant und parallel zueinander an der Stirnseite des Kontaktelementes 10 angeordnet sind.

Figur 3b zeigt dagegen ein alternatives Ausführungsbeispiel eines Kontaktelementes 12 mit einer Bohrung 13 zur Herstellung einer Schraubverbindung.

Schließlich ist das in Figur 3c dargestellte Kontaktelement 14 ähnlich aufgebaut wie das in Figur 3a dargestellte Kontaktelement, wobei die einzelnen Zinken abwechselnd in zwei zueinander parallelen Ebenen 15, 16 gebogen sind, um eine größere Stromtragfähigkeit der Kontaktstellen zu erreichen.

Die Erfindung ist nicht auf die vorstehend beschriebenen Ausführungsbeispiele beschränkt. Vielmehr ist eine Vielzahl von Varianten und Abwandlungen denkbar, die von dem Erfindungsgedanken Gebrauch machen und ebenfalls in den Schutzbereich fallen.

## Patentansprüche

1. Halbbrückenschaltung, insbesondere zum Schalten eines Elektromotors in einem Kraftfahrzeug, mit
einem masseseitigen Schaltelement (1) mit einem Steuereingang (3, G1),
einem spannungsseitigen Schaltelement (2) mit einem Steuereingang (6, G2),
wobei das masseseitige Schaltelement (1) und das spannungsseitige Schaltelement (2) zwischen einem Spannungsanschluss und einem Masseanschluss in Reihe geschaltet werden und zwischen dem spannungsseitigen Schaltelement (2) und dem masseseitigen Schaltelement (1) ein Ausgang (OUT) zur Ansteuerung eines elektrischen Verbrauchers angeordnet ist,
**gekennzeichnet durch**
die Ausführung als integrierte oder umspritzte oder eingegossene Schaltung.

2. Halbbrückenschaltung nach Anspruch 1,
**dadurch gekennzeichnet,**
**dass** die integrierte Schaltung von den beiden Schaltelementen 1, 2) getrennte elektrisch leitfähige Trägerstreifen (G1, G2, D, S, OUT) aufweist, die Anschlusskontakte für die beiden Steuereingänge (3, 6), den Masseanschluss (D), den Spannungsanschluss (S) und/oder den Ausgang (OUT) bilden, wobei die Trägerstreifen mindestens teilweise durch elektrische Verbindungsleitungen (9) mit den Schaltelementen (1, 2) verbunden sind.

3. Halbbrückenschaltung nach Anspruch 1,
**dadurch gekennzeichnet,**
**dass** das spannungsseitige Schaltelement (2) und/oder das masseseitige Schaltelement (1) überstehende Leiterbahnen aufweist, die Anschlusskontakte für den Steuereingang (3, 6), den Spannungsanschluss, den Masseanschluss und/oder den Ausgang bilden.

4. Halbbrückenschaltung nach Anspruch 2 oder 3,
**dadurch gekennzeichnet,**
**dass** die Anschlusskontakte (G1, G2, D, S, OUT) nebeneinander zu einer Seitenkante der integrierten Schaltung hin angeordnet sind.

5. Halbbrückenschaltung nach Anspruch 4,
**dadurch gekennzeichnet,**
**dass** die beiden Anschlusskontakte (G1, G2) für die Steuereingänge der beiden Schaltelemente außen angeordnet sind.

6. Halbbrückenschaltung nach Anspruch 5,
**dadurch gekennzeichnet,**
**dass** der Anschlusskontakt (OUT) für den Ausgang zwischen den beiden Anschlusskontakten (S, D) für den Spannungsanschluss und den Masseanschluss angeordnet ist.

7. Halbbrückenschaltung nach Anspruch 5,
**dadurch gekennzeichnet,**
**dass** der Anschlusskontakt (OUT) für den Ausgang neben den beiden Anschlusskontakten (S, D) für den Spannungsanschluss und den Masseanschluss angeordnet ist.

8. Halbbrückenschaltung nach mindestens einem der vorhergehenden Ansprüche,
**dadurch gekennzeichnet,**
**dass** die beiden Anschlusskontakte (S, D) für den Spannungsanschluss und den Masseanschluss unmittelbar nebeneinander angeordnet sind.

9. Halbbrückenschaltung nach mindestens einem der vorhergehenden Ansprüche,
**dadurch gekennzeichnet,**
**dass** die beiden Anschlusskontakte (S, D) für den Spannungsanschluss und den Masseanschluss zwischen den beiden Anschlusskontakten (G1, G2) für die beiden Steuereingänge angeordnet sind.

10. Halbbrückenschaltung nach mindestens einem der vorhergehenden Ansprüche,
**dadurch gekennzeichnet,**
**dass** die Trägerstreifen (G1, G2, D, S, OUT) und/oder zusätzliche elektrische Kontaktelemente (10, 12, 14) aufgepresst, aufgenietet, aufgelötet oder aufgeschweißt sind.

11. Halbbrückenschaltung nach mindestens einem der vorhergehenden Ansprüche,
**dadurch gekennzeichnet,**
**dass** die Trägerstreifen (G1, G2, D, S, OUT) und/oder die zusätzlichen elektrischen Kontaktelemente (10, 12, 14) eine Bohrung (13) für eine Schraubverbindung oder Zinken (11) für eine Press- oder Lötverbindung aufweisen.

12. Halbbrückenschaltung nach dem vorangehenden Anspruch,
**dadurch gekennzeichnet,**
**dass** die Zinken abwechselnd in zwei zueinander beabstandeten parallelen Ebenen (15, 16) gebogen sind.

13. Halbbrückenschaltung nach mindestens einem der vorhergehenden Ansprüche,
**dadurch gekennzeichnet,**
**dass** die Trägerstreifen, die überstehenden Leiterbahnen und/oder die zusätzlichen Kontaktelemente eine Kupferschicht mit einer Dicke von 35 µm bis 5 mm und vorzugsweise mit einer Dicke von 300 µm aufweisen.

14. Halbbrückenschaltung nach mindestens einem der vorhergehenden Ansprüche,
**dadurch gekennzeichnet,**
**dass** die integrierte Schaltung einlagig aufgebaut ist, während das Substrat der integrierten Schaltung zweilagig ist.
